# EUROPEAN PATENT SPECIFICATION

(11) **EP 1 365 505 B1**
(45) Date of publication and mention of the grant of the patent: **13.02.2008**
(21) Application number: 02011355.1
(22) Date of filing: 23.05.2002
(51) Int. Cl.: H03G 3/30, H03G 3/00

(54) **Low noise RF receiver with high channel separation**
Rauscharmer HF-Empfänger mit hoher Kanaltrennung
Récepteur à bruit faible avec une séparation élevée de canaux

(43) Date of publication of application: 26.11.2003
(73) Proprietor: Sony Deutschland GmbH, 10785 Berlin (DE)
(72) Inventor: Eichel, Dirk, Sony Int. (Europe) GmbH, 70327 stuttgart (DE); Brankovic, Veselin, Sony Int. (Europe) GmbH, 70327 stuttgart (DE)
(74) Representative: Körber, Martin Hans

(56) References cited:
- TAKEUCHI H ET AL: "A single-chip RF front-end for the digital sound broadcasting" INTERNATIONAL CONFERENCE ON CONSUMER ELECTRONICS. 2001 DIGEST OF TECHNICAL PAPERS. ICCE. LOS ANGELES, CA, JUNE 19 - 21, 2001, NEW YORK, NY: IEEE, US, 19 June 2001 (2001-06-19), pages 114-115, XP010552092 ISBN: 0-7803-6622-0
- PATENT ABSTRACTS OF JAPAN vol. 006, no. 099 (E-111), 8 June 1982 (1982-06-08) & JP 57 030424 A (MATSUSHITA ELECTRIC IND CO LTD), 18 February 1982 (1982-02-18)

## Description

The present invention relates to multiband receiver technologies for wireless applications using low noise RF (radio frequency) amplifiers.

CMOS RF technology is of increasing importance for high level integration of low noise analogue circuitry typically used in appliances for Wireless Local Area Networks (WLAN), Local Area Networks (LAN), and Wireless Personal Area Networks (WPAN) as well as in broadcasting applications. Hereby it is a requirement that suitable receivers used in respective consumer electronic equipment has to be produced at very low cost.

Simple RF receiver designs will meet the production cost requirement but not the technical specifications as they are set e.g. for Digital Audio Broadcasting (DAB) or the Japanese Integrated Services Digital Broadcasting - Terrestrial (narrowband) (ISDB-Tn), where the signal levels of adjacent frequency bands, also called channels, may differ in order of magnitudes. A receiver designed for these applications has e.g. to be able to suppress any interference of a strong signal of around 0 dBm at one channel with a weak signal of merely -100 dBm at a further channel. A suppression of an interference of one channel with another or the separation of signals from different frequency bands, respectively, is generally referred to as channel separation.

Presently, two different concepts are favoured to achieve a low cost receiver with sufficient channel separation: The first concept is related to placing intermodulation products in the main band; the second concept focuses on an operation of RF-receivers with an Automatic Gain Control (AGC).

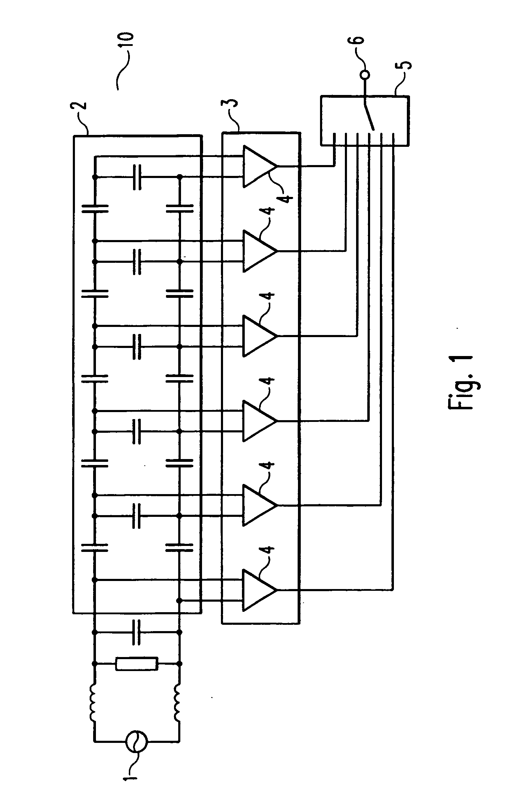

A simple state of the art multiband-RF-receiver layout 10 according to the second concept uses a group of Low Noise Amplifiers (LNA) 3 as shown in Figure 1 (reference?). High-frequency signals supplied from a RF-source 1, usually the antenna of a respective appliance are filtered in a reactance attenuator 2 to separate the different frequency bands of the signal. Next, each frequency band is amplified separately by a respective LNA 4 of the group of LNAs 3. A selector switch 5 finally connects the output of the LNA with the desired frequency band to the output terminal 6 of the circuitry. Neglecting the influence of the reactance attenuator, the channel separation of the shown multiband-RF-receiver is defined by the insulation factor of the selector switch.

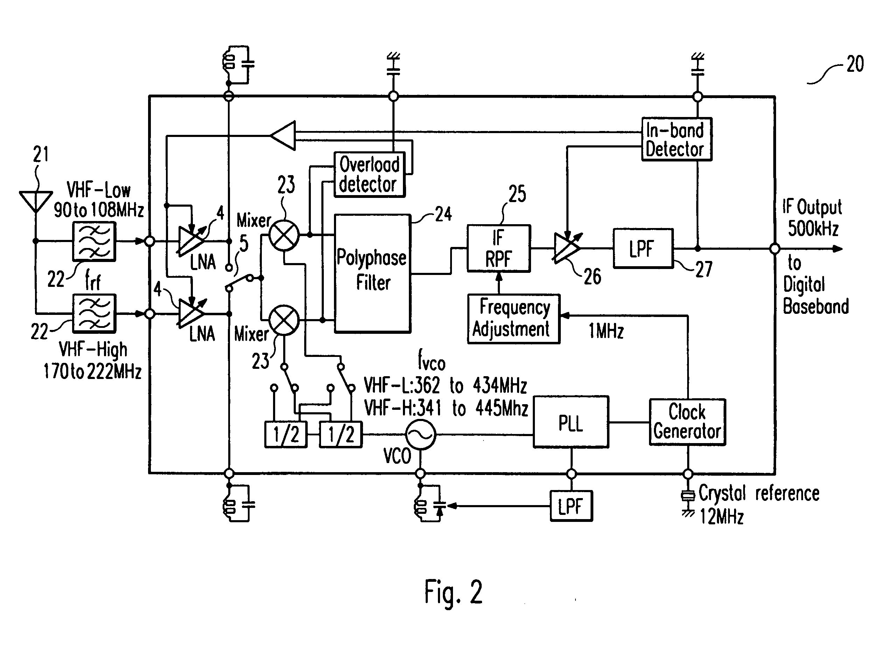

A more sophisticated concept for a multiband-RF-receiver 20 presented by H. Takeuchi et al. (A Single-Chip RF Front-End for The Digital Sound Broadcasting, H. Takeuchi, Taiwa Okanobu, Kenichi Fujimaki, and Nobuo Hareyama, IEEE-Transactions on Consumer Electronics, Vol. 47, No. 3, 2001) is shown in Figure 2. RF-signals received with an antenna 21 are separated by high-frequency band pass filters 22 into separate frequency bands. Each frequency band is then pre-amplified in a low noise preamplifying stage by a LNA 4 of its own. In the example shown, two frequency bands are selected from the antenna output. A selector switch 5 allows to select the desired of the two frequency bands, and passes it to the subsequent mixer stage 23, where it is mixed with an oscillation frequency and converted to a lower frequency band. The resulting signal is then processed by a polyphase filter 24 for image rejection, followed by an intermittent frequency band pass 25 for removing harmonics. A variable gain amplifier 26 then adjusts the signal level to a level required for the digital baseband processing, to which it is passed on after a final low pass filtering 27 for removing higher harmonics produced in the last amplification stage.

The most critical stage of this design is the low noise pre-amplification stage. The pre-amplification stage consists of LNAs arranged in parallel channels for each frequency band, with just one automatic gain control signal applied to all LNAs simultaneously. Each LNAs therefore operates with the same gain as the others, irrespective of the actual signal strength present at its input. Channel separation is therefore only given by the insulation properties of the selector switch connecting the desired frequency band to the mixer input.

Selector switches carried out in CMOS technology usually provide a signal insulation of around -20dB up to -35dB. For a worst case scenario, a difference in the signal strength of two different frequency bands of up to 100 dB has to be taken into account. As the signals of both frequency bands are amplified with an identical gain, the insulation factor of the selector switch might not be sufficient to prevent cross-talking from the strong signal channel into the weak signal channel.

It is therefore an object of the present invention to provide a low noise amplifier circuit for a multiband-RF-receiver, and a multiband-RF-receiver with a high separation or insulation, respectively, of the different frequency bands from each other.

This object is achieved according to the invention as defined in the independent claims.

The above object is achieved in particular by a low noise amplifier circuit for a multiband-RF-receiver with at least two separate amplification channels, whereby each amplification channel comprises a low noise amplifier with an automatic gain control enabling terminal for amplifying a RF-input-signal into a RF-output-signal at a gain individually controlled by a respective gain control signal applied to the automatic gain control enabling terminal, an output line, which is selectively connectable to a common output of the amplifier circuit by means of a selector switch, the switching condition of which is controlled by a selection signal, and at least one controllable switching unit placed within the connecting line from the output terminal of the low noise amplifier to the output line of the respective amplification channel, whereby the controllable switching unit is adapted to disconnect or connect a section of the connecting line according to a switch control signal applied to it.

The above object is further achieved by a multiband-RF-receiver comprising a low noise amplifier circuit of a kind according to the present invention, an automatic gain control means for controlling the gain of each amplification channels of said low noise amplifier circuit separately, a mixing means for mixing a signal received from the output of said low noise amplifier circuit with an oscillation frequency band to convert it to a lower frequency band, and a complex filter means for to filter and further amplify a signal received from said mixing means.

The present invention advantageously enables a gain control in an amplification channel independent from that in other amplification channels, so that the finally achievable channel separation is not defined by the insulating properties of the selector switch only, but can be increased by the insulating properties of the components used in each of the amplification channels used for frequency bands, which are not selected for reception.

Further developments are set forth in the dependent claims.

As the signal strength on different frequency bands may differ by orders of magnitude, more than one gain is advantageously provided for each amplification channel in that a low noise amplifier comprises two automatic gain control terminals for a stepwise gain control of the amplification of a RF-input-signal into a RF-output signal.

In a preferred embodiment of the present invention, the gain of the low noise amplifier is continuously adjustable by a respective gain control signal, thereby advantageously enabling to adapt the gain of a low noise amplifier to the signal strength of the frequency band for the respective amplification channel.

The low noise amplifier and/or the controllable switching unit and/or the selector switch are preferably carried out in CMOS and/or BiCMOS and/or SiGe technology to achieve a high insulating resistance between not through-connected terminals of these components for a low noise amplifier circuit according to the present invention.

In a further preferred embodiment of the present invention, the low noise amplifier circuit is carried out as a monolithic integrated circuit or as a part thereof allowing a cost-effective technical implementation.

A multiband-RF-receiver according to the present invention is further advantageously equipped with an automatic gain control block for adjusting the level of a signal received from the complex filter means to the requirements set for the subsequent baseband processing.

A low noise amplifier circuit and a multiband-RF-receiver according to the present invention are particularly useful for digital broadcasting applications like e.g. ISDB-Tn, DAB or the like. But more generally, the field of application for the present invention is any communication system, where two or more frequency bands have to be dealt with.

In the following specification, the present invention is explained in more detail with respect to special embodiments, and in relation to the enclosed drawings, in which
- Figure 1: shows a first example of a prior art low noise amplification circuit for a multiband-RF-receiver,
- Figure 2: shows a multiband-RF-receiver with a second example of a prior art low noise amplification circuit,
- Figure 3: is a block diagram showing the circuit principles of a low noise amplifier circuit for a first embodiment of the present invention,
- Figure 4: is a block diagram of a second embodiment of the present invention,
- Figure 5: is a block diagram of a third embodiment of the present invention,
- Figure 6: is a block diagram of a fourth embodiment of the present invention,
- Figure 7: is a schematic of a multiband-RF-receiver according to the present invention,
- Figure 8: shows a circuit example for a LNA implemented in CMOS technology,
- Figure 9: shows the frequency dependence of the gain of a LNA according to the illustration of Figure 8 for three different operation modes,
- Figure 10: shows a circuit example for a controllable switching unit implemented in CMOS technology, and
- Figure 11: shows the frequency dependence of the attenuation of a controllable switching unit according to the illustration of Figure 10 for a 'switched-on' and a 'switched-off' mode.

In the drawings, equal reference characters refer to equivalent parts throughout the different illustrations.

The prior art multi-channel amplifier circuits shown in Figure 1 and Figure 2, which are described in more detail above, use one common gain control signal for setting the gain in all amplification channels to an equal value. If a frequency band with a weak signal is chosen for reception, the gain has to be set to a high value. The prior art circuits will then also amplify strong signals of other frequency bands in their respective amplification channels with the same gain, and supply those to the selector switch 5. The insulating properties of the selector switch may not be sufficient to avoid a cross-talking from a line with an unwanted but even so amplified strong signal to a line with a weak but wanted signal.

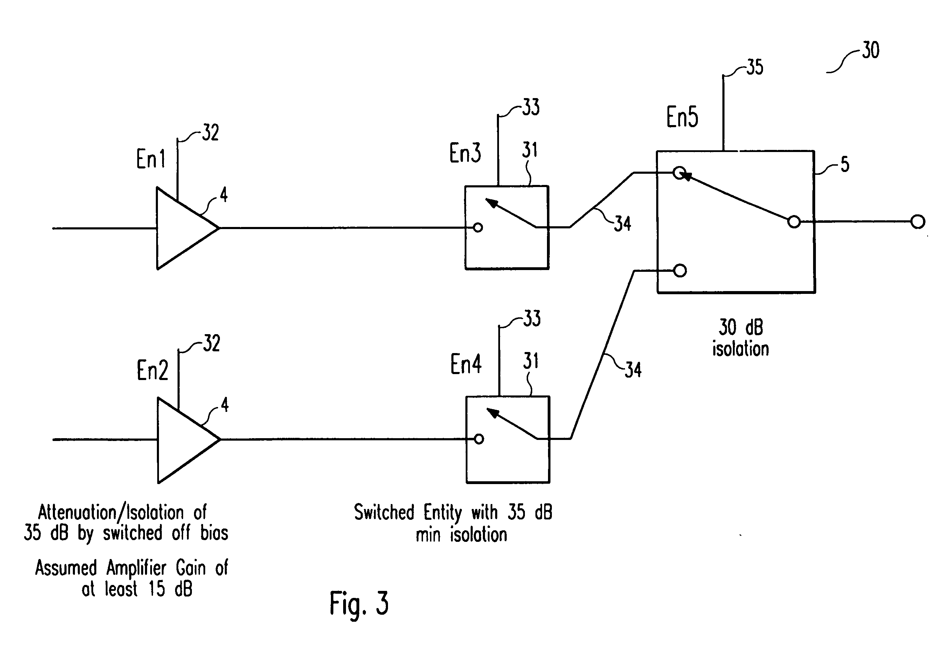

The block diagram of a low noise amplifier circuit 30 according to a first embodiment of the present invention is shown in Figure 3. The low noise amplifier circuits shown in Figure 3 through Figure 7 comprise only two amplification channels for elucidating the fundamentals of the present invention. But it is to be understood, that a low noise amplifier circuit according to the present invention may contain further amplification channels.

In the first embodiment of the present invention, each amplification channel is composed of a low noise amplifier (LNA) 4 at the input of the amplification channel, and a controllable switching unit 31 placed in series between the output of the LNA and the output line 34 of the amplification channel. The LNA 4 is provided with a gain control enabling terminal 32 enabling an automatic gain control of the LNA 4 by means of a gain control signal. A control terminal 33 at the controllable switching unit allows to set the switching condition of the unit by applying an appropriate switch control signal. The output line 34 of each amplification channel connects the output terminal of the controllable switching unit with a respective input terminal of the selector switch 5. The single output terminal of the selector switch 5 is connected to the next stage in a respective multiband-RF-receiver, usually the mixer stage.

Signals obtained from an antenna or a wired connection are first split up in different separate frequency bands by a suitable filter circuit, which is not subject to the present invention. Each frequency band is then fed to just one of the amplification channels of a low noise amplifier circuit according to the present invention. The number of required amplification channels for a multiband-RF-receiver is therefore given by the number of frequency bands for which it is laid out.

In the most simple embodiment of the present invention, the LNAs 4 can be operated with two different gains controlled by a gain control signal En1 or EN2, respectively. For a first value of the gain control signal denoted as '0', a LNA is operated in the 'turned-off'-mode, and for a second value of the gain control signal denoted as ' '1', a LNA is operated in the 'turned-on'-mode.

While in the 'turned-on'-mode, a LNA amplifies a RF-input-signal into a RF-output-signal with a specific gain, e.g. 0 dB, 15 dB, 25 dB or the like, in the 'turned-off'-mode, the output of a LNA galvanically isolated from its input. The achievable insulation values between input and output of an LNA are with up to 35 dB particularly high for LNAs carried out in a CMOS (Complementary Metal Oxide Semiconductor) or BiCMOS (Bipolar CMOS) design, particularly when implemented with SiGe process technology. Besides the excellent insulating properties, these technologies further allow a construction of very low noise RF-amplifiers and switching devices, which usage is preferred for the present invention.

With respect to a highest attainable channel separation, the amplification channels are operated independently from each other. While one is used to amplify the desired signal, all others are set to provide a maximum resistance against a passage of an electrical signal. This is achieved by setting appropriate control values for the gain 32 (En1 and En2) and switch 33 (En3 and En4) control signals of the respective amplification channels.

Figure 3 shows an amplifier circuit according to a first embodiment of the present invention with the upper amplification channel selected for signal reception. The lower, and further amplification channels which are not shown in the figure, are set to block off any passage for a not selected frequency band. The channel separation can then be expressed as the sum of all resistance or insulating values, respectively, along a not selected amplification channel and the insulation value between the terminals of the selector switch 5.

An overview over all possible modes of operation of an amplifier according to the representation of Figure 3 is given in Table 1 below. Hereby it is assumed, that the insulation value between the terminals of the selector switch 5 as well as for an open controllable switching unit 31 is 35 dB. The controllable switching unit is open for a switch control signal of logical value '0', and closed for a switch control signal having a logical value of '1'. The gain of a LNA 4 is assumed to be 15 dB in the 'turned-on'-mode (En1, En2='1') and -35 dB in the 'turned-off'-mode (En1, En2='0'). A logical value for the selection signal En5 of '1' means, that the selector switch is set to connect with the upper amplification channel, and a logical value of '0' indicates, that it is connected to the lower amplification channel. For a shorter denomination, the upper amplification channel is in the following tables denoted as upper branch, and analogously the lower amplification channel as lower branch.

**Table 1: Modes of operation for a first embodiment of the present invention**

| **Control signal combination ID** | **En1** | **En2** | **En3** | **En4** | **En5** | **Gain (dB) upper branch** | **Gain (dB) lower branch** |
|---|---|---|---|---|---|---|---|
| **1** | 1 | 0 | 1 | 0 | 1 | 15 | -70 |
| **2** | 1 | 0 | 0 | 0 | 1 | -20 | -70 |
| **3** | 0 | 0 | 1 | 0 | 1 | -35 | -70 |
| **4** | 0 | 0 | 0 | 0 | 1 | -70 | -70 |
| **5** | 0 | 1 | 0 | 1 | 0 | -70 | 15 |
| **6** | 0 | 1 | 0 | 0 | 0 | -70 | -20 |
| **7** | 0 | 0 | 0 | 1 | 0 | -70 | -35 |
| **8** | 0 | 0 | 0 | 0 | 0 | -70 | -70 |

For the example shown, an attenuation of 70 dB is achieved for a signal passing through a non used amplification channel. Adding the attenuation between the terminals of the selector switch 5, a total attenuation for not selected channels of 105 dB is achieved.

The most useful operation modes are those denoted with a control signal combination ID of ' 1' or '5', which means that either the upper or the lower amplification channel is set to full amplification while the respective other amplification channel is set to block off any signal passage. But, particularly for very strong selected signals, one of the other control signal combinations may be used to avoid an overload of subsequent subsystems of the multiband-RF-receiver.

The advantage of the present invention as compared with an amplification circuit as shown in Figures 1 and 2 are best understood by calculation the channel separation for two signals of different frequency bands with the first signal having a high level of 0 dBm, and the second low level of only -100 dBm. Assumed the gain of an LNA can be chosen to be either 15 dB or -35 dB, the signal levels present at the respective terminals of the selector switch 5 in the prior art examples will be 15 dBm and -85 dBm, respectively, while for an amplifier circuit according to the present invention (assumed the weak signal is selected) the signal levels will be -70 dBm and -85 dBm, respectively. As the signal attenuation given by the insulation between the terminals of the selector switch 5 is assumed to 35 dBm, there will not only be a considerable cross-talking from the high level signal to the low level signal of -20 dBm, which corresponds rather to an overriding of the selected weaker signal than an interference. For the present invention, the level of interference originating from the high level signal is reduced to a value of -105 dBm being considerably smaller than the level of the wanted signal with -85 dBm.

Further, when the high level signal of 0 dBm is selected for reception, it may be appropriate to attenuate the signal instead of amplifying it before it is handed to the next stage of the multiband-RF-receiver. Theoretically, three attenuation steps represented by the control signal combination IDs '2' to '4' and '6' to '8', respectively, are possible. The most practical application will be either that denoted by a control signal combination ID of '2' or '6', where the signal is amplified in the LNA 4 and subsequently attenuated in the open controllable switching unit 31, thus achieving an overall attenuation of 20 dB, or that denoted by a control signal combination ID of '3' or '7', where the signal is attenuated in the LNA 4 but can pass the controllable switching unit 31 without further attenuation, thus resulting in an overall attenuation of 35 dB.

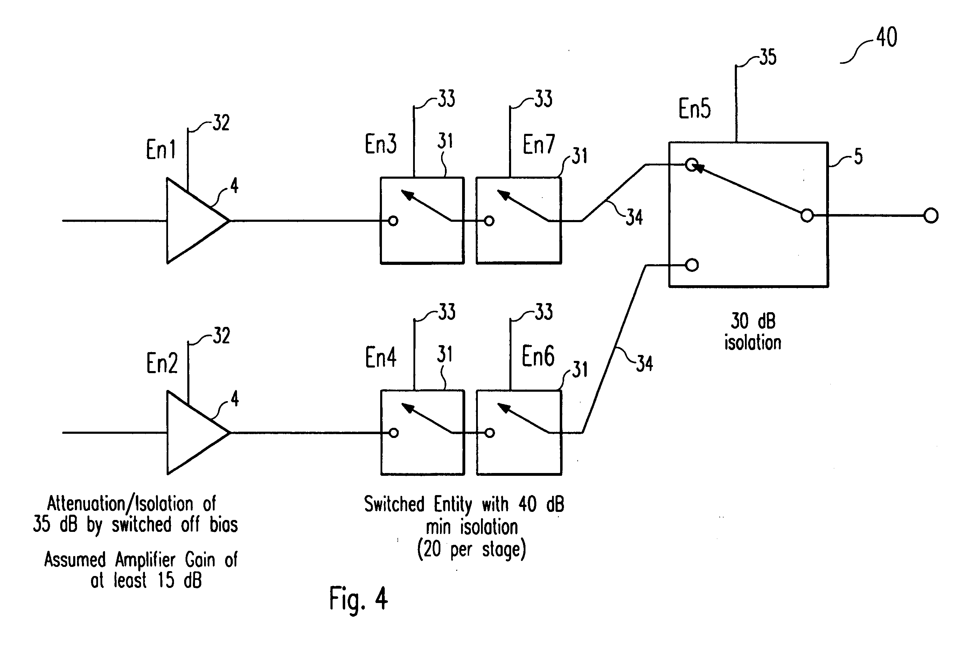

For some applications the channel separation achieved with a circuit layout presented in Figure 3 may not be sufficient. To increase it, additional controllable switching units 31 may be added in the amplification channels as shown for a second embodiment of the present invention in Figure 4. Besides providing higher channel separation, the system of Figure 4 further allows a more sensible control of selective amplification channel attenuation than the first embodiment of Figure 3, particularly when controllable switching units (CSU) with lower insulating properties are used.

All possible modes of operation for a low noise amplifier circuit 40 according to the representation of Figure 4 are given in Table 2 below. As distinct from the example given in Table 1, the insulation for the controllable switching unit is hereby set to a lower value of only 20 dB allowing the usage of simpler switching units and a finer gradation of the amplification/attenuation steps.

**Table 2: Modes of operation for a second embodiment of the present invention**

| **Control signal combination ID** | **En1** | **En2** | **En3** | **En4** | **En5** | **En6** | **En7** | **Gain (dB) upper branch** | **Gain (dB) lower branch** |
|---|---|---|---|---|---|---|---|---|---|
| **1** | 1 | 0 | 1 | 0 | 1 | 0 | 1 | 15 | -75 |
| **2** | 1 | 0 | 0 | 0 | 1 | 0 | 1 | -5 | -75 |
| **3** | 1 | 0 | 0 | 0 | 1 | 0 | 0 | -25 | -75 |
| **4** | 0 | 0 | 1 | 0 | 1 | 0 | 1 | -35 | -75 |
| **5** | 0 | 0 | 0 | 0 | 1 | 0 | 1 | -55 | -75 |
| **6** | 0 | 0 | 0 | 0 | 1 | 0 | 0 | -75 | -75 |
| **7** | 0 | 1 | 0 | 1 | 0 | 1 | 0 | -75 | 15 |
| **8** | 0 | 1 | 0 | 0 | 0 | 1 | 0 | -75 | -5 |
| **9** | 0 | 1 | 0 | 0 | 0 | 0 | 0 | -75 | -25 |
| **10** | 0 | 0 | 0 | 1 | 0 | 1 | 0 | -75 | -35 |
| **11** | 0 | 0 | 0 | 0 | 0 | 1 | 0 | -75 | -55 |
| **12** | 0 | 0 | 0 | 0 | 0 | 0 | 0 | -75 | -75 |

The achievable signal attenuation in an amplification channel can further be increased by adding even more CSUs and/or LNAs. This further allows to control the overall amplification/attenuation of an individual amplification channel in a more subtle way than with the example shown in Figure 4.

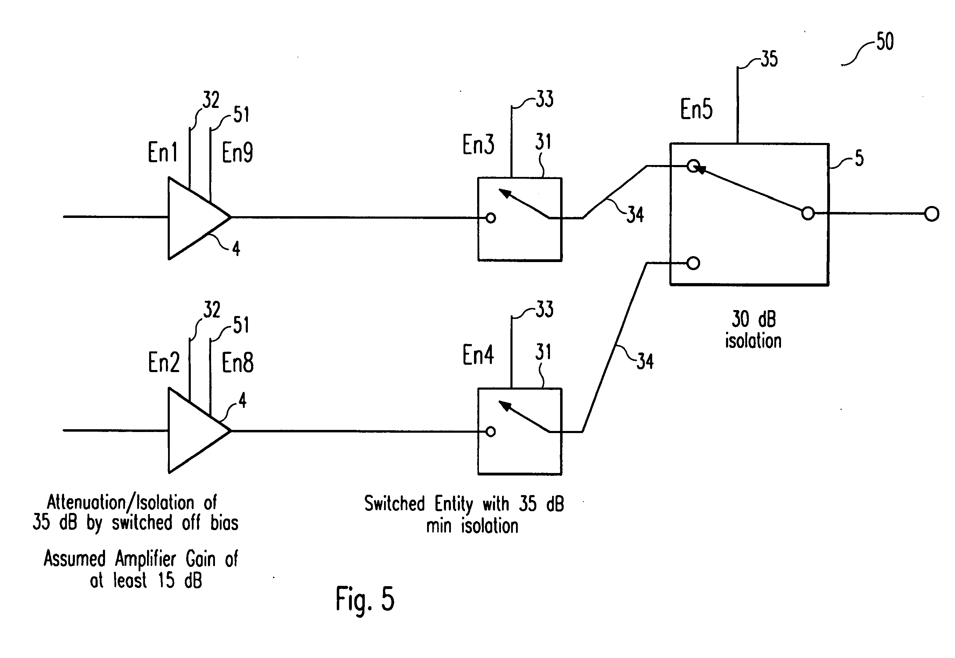

With reference to Figure 5, a third embodiment 50 of the present invention is shown. Each LNA used in this circuit design is equipped with two automatic control terminals 32 and 51 for applying two gain control signals En1 and En9 or En2 and En8, respectively independent from each other. Each gain control signal can take in two levels denoted with '1' and '0'. Table 3 gives an overview of the control states and the respectively adjusted amplifier gain for the LNA of the upper amplification channel, which analogously applies to the LNA of the lower or further amplification channels.

**Table 3: Relation between gain control signal combinations and gain of LNA**

| **Gain control signal combination ID** | **En1** | **En9** | **Gain** |
|---|---|---|---|
| **1** | 1 | 0 | First gain |
| **2** | 0 | 1 | Second gain |
| **3** | 0 | 0 | Full attenuation |

By enabling to operate a LNA at two different gains as well as at full attenuation, a finer gradation of the amplification/attenuation steps is achieved without adding additional components to the amplification channels. The respective amplification/attenuation values which can be set for the example shown in Figure 5 are listed in Table 4 below. The listed values for the gain in the upper and lower branch are based on a first gain for an LNA of 15 dB, a second gain of 0 dB, an insulation factor for the LNA at full attenuation of 35 dB, an attenuation of an open CSU of likewise 35 dB, and an insulation factor between the terminals of the selector switch of 30 dB.

**Table 4: Modes of operation for a third embodiment of the present invention**

| **Control signal combination ID** | **En1** | **En2** | **En3** | **En4** | **En5** | **En8** | **En9** | **Gain (dB) upper branch** | **Gain (dB) lower branch** |
|---|---|---|---|---|---|---|---|---|---|
| **1** | 1 | 0 | 1 | 0 | 1 | 0 | 0 | 15 | -70 |
| **2** | 0 | 0 | 1 | 0 | 1 | 0 | 1 | 0 | -70 |
| **3** | 1 | 0 | 0 | 0 | 1 | 0 | 0 | -20 | -70 |
| **4** | 0 | 0 | 0 | 0 | 1 | 0 | 1 | -35 | -70 |
| **5** | 0 | 0 | 0 | 0 | 1 | 0 | 0 | -70 | -70 |
| **6** | 0 | 1 | 0 | 1 | 0 | 0 | 0 | -70 | 15 |
| **7** | 0 | 0 | 0 | 1 | 0 | 1 | 0 | -70 | 0 |
| **8** | 0 | 1 | 0 | 0 | 0 | 0 | 0 | -70 | -20 |
| **9** | 0 | 0 | 0 | 0 | 0 | 1 | 0 | -70 | -35 |
| **10** | 0 | 0 | 0 | 0 | 0 | 0 | 0 | -70 | -70 |

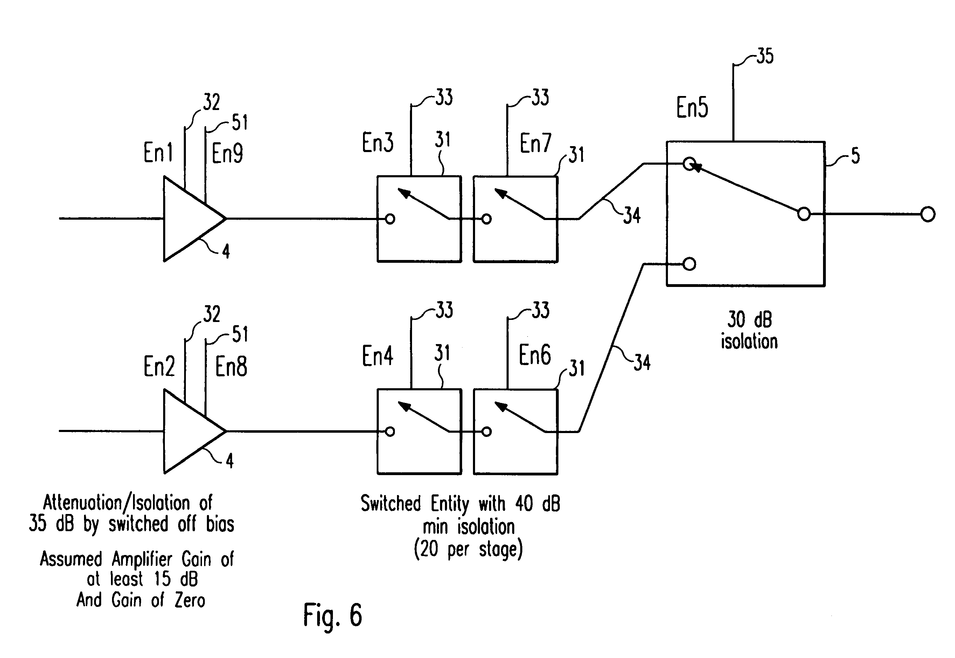

The fourth embodiment of the present invention is shown in Figure 6. Practically it represents a combination of the third with the second embodiment explained above, as LNAs with two gain control enabling terminals 32 and 51 are used combined with two CSUs in series for each amplification channel. The identities of all control signals are indicated in Figure 6. As can be seen from the list of operation modes for the amplifier circuit of this fourth embodiment in Table 5, this embodiment allows a more subtle graduation of the amplification/attenuation steps than the embodiments presented above. Further, the technical specifications for the components used in an amplification channel can hereby be reduced as compared to an embodiment like shown in Figure 5, allowing to implement an attenuation of 70 dB for each amplification channel with components of lower performance.

The values for the gain in the upper and lower branch listed in Table 5 are based on a first gain for an LNA of 15 dB, a second gain of 0 dB, an insulation factor for the LNA at full attenuation of 35 dB, an attenuation of an open CSU of 20 dB, and an insulation factor between the terminals of the selector switch of 30 dB.

**Table 5: Modes of operation for a fourth embodiment of the present invention**

| **Control signal combination ID** | **En1** | **En2** | **En3** | **En4** | **En5** | **En6** | **En7** | **En8** | **En9** | **Gain (dB) upper branch** | **Gain (dB) lower branch** |
|---|---|---|---|---|---|---|---|---|---|---|---|
| **1** | 1 | 0 | 1 | 0 | 1 | 0 | 1 | 0 | 0 | 15 | -75 |
| **2** | 0 | 0 | 1 | 0 | 1 | 0 | 1 | 0 | 1 | 0 | -75 |
| **3** | 1 | 0 | 0 | 0 | 1 | 0 | 1 | 0 | 0 | -5 | -75 |
| **4** | 1 | 0 | 0 | 0 | 1 | 0 | 0 | 0 | 0 | -25 | -75 |
| **5** | 0 | 0 | 1 | 0 | 1 | 0 | 1 | 0 | 0 | -35 | -75 |
| **6** | 0 | 0 | 1 | 0 | 1 | 0 | 0 | 0 | 0 | -55 | -75 |
| **7** | 0 | 0 | 0 | 0 | 1 | 0 | 0 | 0 | 0 | -75 | -75 |
| **8** | 0 | 1 | 0 | 1 | 0 | 1 | 0 | 0 | 0 | -75 | 15 |
| **9** | 0 | 0 | 0 | 1 | 0 | 1 | 0 | 1 | 0 | -75 | 0 |
| **10** | 0 | 1 | 0 | 0 | 0 | 1 | 0 | 0 | 0 | -75 | -5 |
| **11** | 0 | 1 | 0 | 0 | 0 | 0 | 0 | 0 | 0 | -75 | -25 |
| **12** | 0 | 0 | 0 | 1 | 0 | 1 | 0 | 0 | 0 | -75 | -35 |
| **13** | 0 | 0 | 0 | 1 | 0 | 0 | 0 | 0 | 0 | -75 | -55 |
| **14** | 0 | 0 | 0 | 0 | 0 | 0 | 0 | 0 | 0 | -75 | -75 |

As can be seen from the representation of Table 5, the embodiment of Figure 6 allows to implement high channel separation with components of lower insulating specifications as it is possible for embodiments discussed before.

Up to now, it was assumed, that all components work without any insertion loss. But insertion losses have to be taken into account for a practice-related circuit design. To achieve the target gain for a selected amplification channel, a high enough amplifier gain of the LNA has to be chosen to compensate all insertion losses of the components used in that specific amplification channel. Assumed the insertion loss of a switching component totals to 5 dB, than the amplifier gain has to be increased by 5 dB for every switch (CSU and selector switch) used in the circuit chain from the LNA output to the input of the subsequent stage of the multiband-RF-receiver.

Further, it is assumed in the above description of the various embodiments of the present invention, that an LNA is operated at certain fixed gains only between which it is switched back and forth according to the operation mode selected. Ideally, the signal level is kept constant at certain locations of a multiband-RF-amplifier. Those locations are typically the output of the mixer stage or the output of the multiband-RF-receiver to the baseband processing. Such a constant signal value control can best be achieved with a closed loop control circuit, which produces a continuously variable gain control signal for continuously adjusting the gain of a respective LNA to keep the respective signal at constant value.

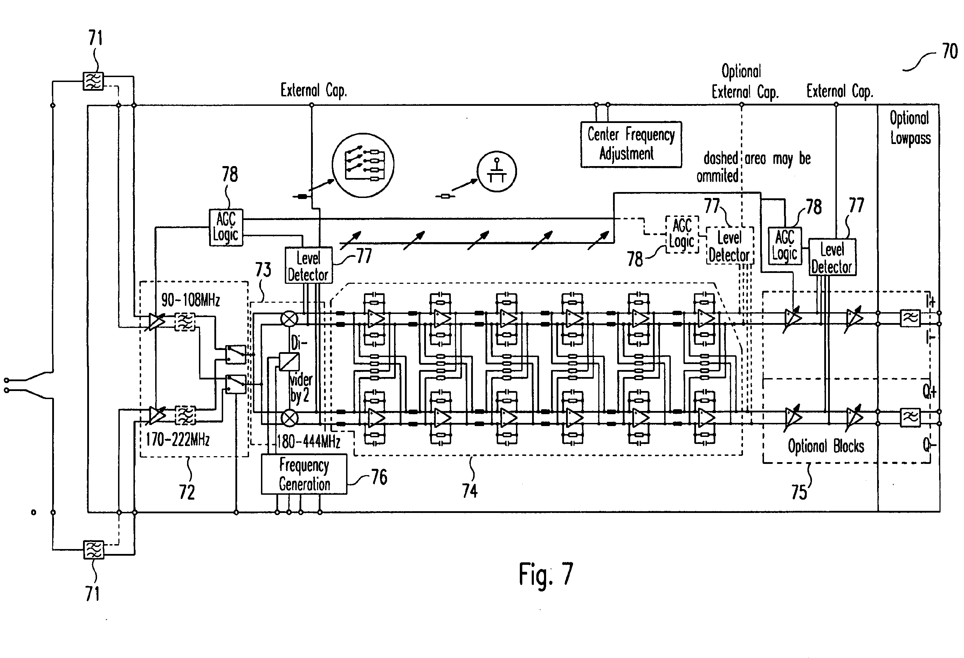

With respect to Figure 7 a schematic representation of a multiband-RF-receiver 70 according to the present invention is shown. The frequency bands of a signal supplied from a signal source not shown in the figure are first separated by bandpass filters 71 and then provided separately to the amplification channels of a low noise amplifier circuit 72 according to the present invention. Typical frequency bands for the ISDB-Tn system would be e.g. a first band ranging from 90 to 108 MHz, and a second ranging from 170 to 222 MHz. The amplifier circuit may be of any of the embodiments discussed above. Additionally, it may comprise a bandpass filter for cleaning the signals from harmonics after amplification as shown in Figure 7. The variable gain amplifiers of the low noise amplifier circuit 72 shown in Figure 7 are representative for a complete amplification channel according to an embodiment described above.

Although a separation and further processing of only two frequency bands is shown with regard to a clear representation, it is to be noted, that the invention also applies to more than two frequency bands for selection. For every additional frequency band, an extra bandpass filter 71 and an additional amplification channel for the amplifier circuit 72 has to be added.

The multiband-RF-receiver 70 of Figure 7 shows a differential type receiver with two separate lines indicating the signal path for the in-phase and the in-quadrature phases of a respective signal. Therefore two parallel operating selector switches are necessary for the two orthogonal phases as shown. Both phases for the selected frequency band are then supplied to the mixer stage 73 where they are downconverted to the intermittent frequency. For ISDB-Tn applications, the mixer stage uses a reference frequency band ranging from 180 to 444 MHz, which is divided by two before being supplied to the mixers of the stage. The reference oscillation frequency band is supplied from a frequency generator 76.

Subsequent to the mixing stage, a complex filter 74 provides bandpass filtering combined with image rejection comprising interlinked chains of active filter elements. Inductances or resistors of the active filter components may be replaced by resistor cascades or MOS transistors as indicated in the insertions of Figure 7.

Optionally, a further block 75 with automatic gain controlled LNAs levels the signal provided at the output of the complex filter 74 to adjust the signal level to the requirements of the subsequent baseband processing. Final, optional lowpasses in block 75 remove higher harmonics, before the in-phase and in-quadrature signals are supplied to the baseband processing circuitry.

The schematic representation of Figure 7 shows two different locations for a level detection to based on which an automatic gain control for the LNAs of the amplifier circuit 72 can be realised. The first location is the output of the mixer station 73, the alternative location is the output of the complex filter 74. The signal strength at one of the two possible locations is measured by a level detector unit 77, which provides a level signal indicative of the measured signal level to an automatic gain control (AGC) logic 78, which for its part produces a gain control signal supplied to the gain control enabling terminal of a LNA of the amplifier circuit 72. The AGC logic 78 further controls all switches of each amplification channel to set on all channels proper amplification/attenuation values necessary for a good signal quality of the selected frequency band.

For ISDB-Tn applications, the gain of an LNA of a selected frequency band is favourably set to a value which sets the signal level at the input of the mixer stage to a value lower than -30 dBm. The filter gain of the complex filter is for instance laid out to around 40 dB.

The gain of the LNAs used in block 75 is also adjusted by a closed loop control with a level detector unit 77 and an AGC logic 78 in the feedback loop. The maximum gain of the automatic gain control block 75 is e.g. set down to 40 dB.

Although the layout for a multiband-RF-receiver has only been shown for a differential type receiver, it is clear that the system structure also applies to a less complex single ended type of a receiver structure.

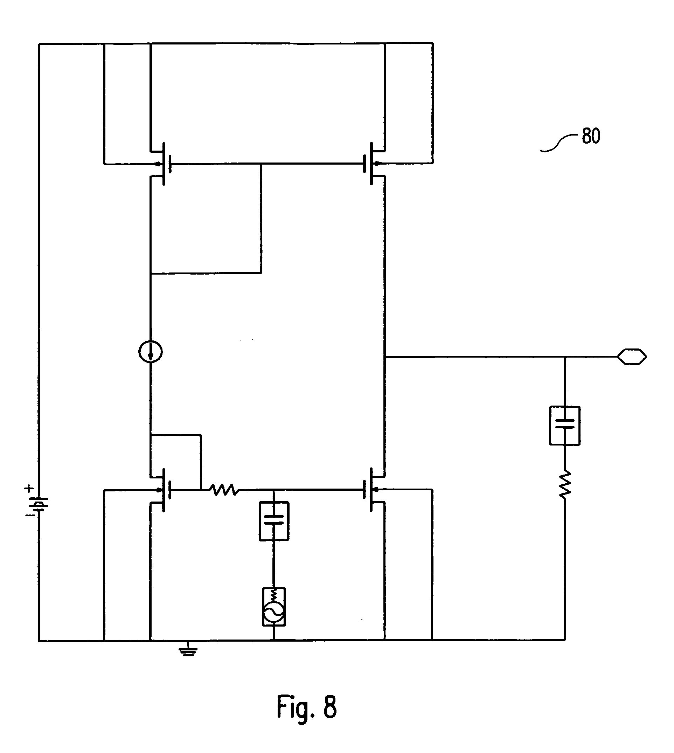

The amplification/attenuation behaviour of a LNA carried out in CMOS technology was simulated on the LNA circuit design 80 shown in Figure 8. The results of the simulation are shown in Table 6. For a 15 dB gain as it is used to amplify weak signals, the gain control signal I_{ds} was set to 0.8 mA. The resulting noise factor of 2.27 and third order distortion level IIP3 of 2.6 dBm are well within the safe range. For strong signals, the amplifier gain is set to 0 dB with a gain control signal I_{ds} of 0.08 m. The resulting noise factor of 6 represents no problem due to the strength of the signal. Also the third order distortion level IIP3 of -5.8 dBm is well within safety. Setting the gain control signal to a value of I_{ds} = 0 mA, the LNA is operated in the attenuation mode with an achieved attenuation of 30 dB. The noise factor as well as the third order distortion level of 27 dBm are in this case not relevant, because practically no signal is available.

**Table 6: Simulation values obtained for a CMOS-LNA according to Figure 8**

| **Operation Mode** | **I_{ds} (mA)** | **Gain (dB)** | **Noise Factor** | **IIP3 (dBm)** |
|---|---|---|---|---|
| **1** | 0.8 | ≈ 15 | 2.75 | 2.6 |
| **2** | 0.08 | ≈ 0 | 6 | -5.8 |
| **3** | 0 | ≈ -30 | --- | 27 |

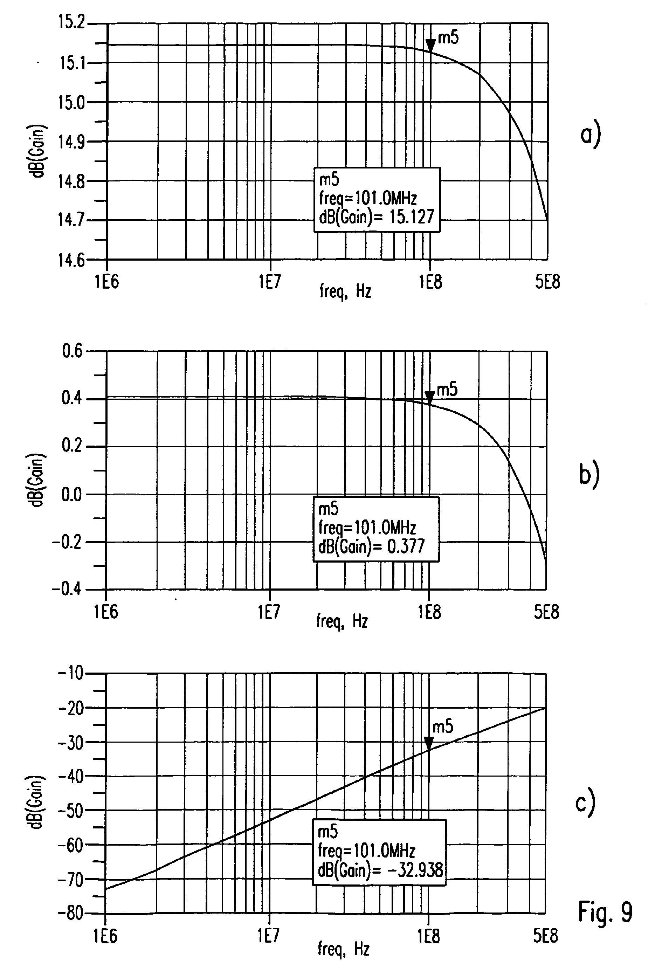

The behaviour of the LNA gain versus the frequency of the input signal is shown in Figure 9. Representation a) of this figure shows the graph of the gain for operation mode 1 of Table 6. The gain is above 15 dB for frequency below approximately 250 MHz. Representation b) of Figure 9 shows the graph of the gain for operation mode 2. Like for operation mode 1, the gain is approximately constant for frequencies below 100 MHz. The 0 dB threshold is reached for a frequency of around 350 MHz. Representation c) of Figure 9 shows the graph operation mode 3 of Table 6. The attenuation decreases exponentially with increasing frequency, but stays well below 30 dB for signals with a frequency below 100 MHz. An insert in the co-ordinate areas of the three graphs gives the exact gain values for a frequency of 101.0 MHz. The respective point is indicated as 'm5'on each graph.

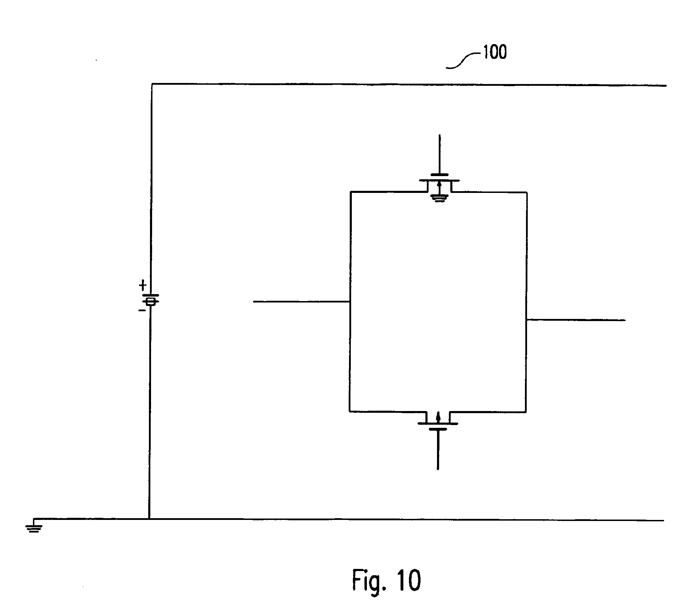

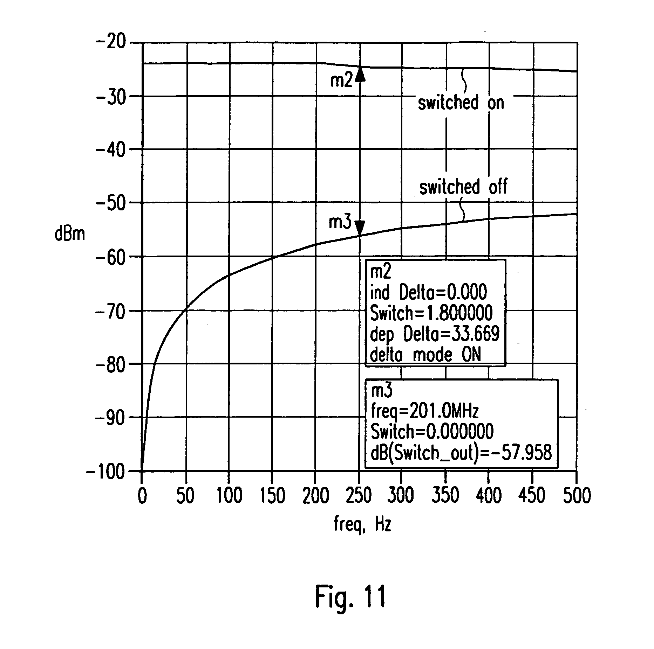

The simulated frequency behaviour of a CMOS controllable switching unit as shown in the schematic circuit layout 100 of Figure 10 is given in Figure 11 for a 'switched-on' and a 'switched-off' mode. The upper graph in Figure 11 shows the signal level at the output of a respective controllable switching unit (CSU) for an input signal level of - 22dB. The respective attenuation of the signal therefore stays below 5 dB for the complete test frequency range. In the 'switched-off' mode, the attenuation decreases with increasing frequency. The respective signal level at the output of the CSU stays well below -50 dB within the test frequency range.

The measured output signal levels at 201.0 MHz for the 'switched-on' mode (see point 'm2') and the 'switched-off' mode (see point 'm3') are -24.289 dBm and -57.958 dBm. The difference in the attenuation between the 'switched-on' and the 'switched-off' mode is therefore 33.669 dB as shown in the upper insert for the value of 'dep. Delta'. The two different values for 'Switch' of both inserts are the respective values for the switch control signal for the 'switched-on' and the 'switched-off' mode.

Two identical switches used in series, operate like on single switch with doubled attenuation factors, particularly when the share a common switch control signal.

## Claims

1. A low noise amplifier circuit for a multiband-RF-receiver with at least two separate amplification channels, whereby each amplification channel comprises
a low noise amplifier (4) with an automatic gain control enabling terminal (32) for amplifying a RF-input-signal into a RF-output-signal at a gain individually controlled by a respective gain control signal applied to said automatic gain control enabling terminal (32),
an output line (34), which is selectively connectable to a common output of the amplifier circuit by means of a selector switch (5), the switching condition of which is controlled by a selection signal, and
at least one controllable switching unit (31) placed in the connecting line between the output terminal of said low noise amplifier (4) and said output line (34) of the respective amplification channel, whereby said controllable switching unit (31) is adapted to disconnect or connect a section of said connecting line according to a switch control signal applied to it.

2. A low noise amplifier circuit according to claim 1,
**characterised in**
**that** the gain of the low noise amplifier (4) is continuously adjustable by said gain control signal.

3. A low noise amplifier circuit according to claim 1,
**characterised in**
**that** said low noise amplifier (4) comprises two automatic gain control terminals (32, 51) for a stepwise gain control of the amplification of a RF-input-signal into a RF-output-signal.

4. A low noise amplifier circuit according to claim 1, 2 or 3,
**characterised in**
**that** said low noise amplifier (4) and/or said controllable switching unit (31) and/or said selector switch (5) is carried out in CMOS technology.

5. A low noise amplifier circuit according to one of the claims 1 to 4,
**characterised in**
**that** said low noise amplifier (4) and/or said controllable switching unit (31) and/or said selector switch (5) is carried out in BiCMOS technology.

6. A low noise amplifier circuit according to one of the claims 1 to 5,
**characterised in**
**that** said low noise amplifier (4) and/or said controllable switching unit (31) and/or said selector switch (5) is carried out in SiGe technology.

7. A low noise amplifier circuit according to one of the claims 1 to 6,
**characterised in**
**that** said low noise amplifier circuit is carried out as a monolithic integrated circuit or as a part thereof.

8. A multiband-RF-receiver comprising
a low noise amplifier circuit according to one of the claims 1 to 7,
an automatic gain control means (78) for controlling the gain of each amplification channels of said low noise amplifier circuit (72) separately,
a mixing means (73) for mixing a signal received from the output of said low noise amplifier circuit (72) with an oscillation frequency band to convert it to a lower frequency band, and
a complex filter means (74) for to filter and further amplify a signal received from said mixing means (73).

9. A multiband-RF-receiver according to claim 8,
**characterised by**
an automatic gain control block (75) for adjusting the level of a signal received from the complex filter means (74)to the requirements set for the subsequent baseband processing.

## Patentansprüche

1. Rauscharme Verstärkerschaltung für einen Mehrband-HF-Empfänger mit wenigstens zwei getrennten Verstärkungskanälen, wobei jeder Verstärkungskanal aufweist:
einen rauscharmen Verstärker (4) mit einem Anschluss (32) zum Ermöglichen einer automatischen Verstärkungsregelung zum Verstärken eines HF-Eingangssignals in ein HF-Ausgangssignal mit einem Verstärkungsfaktor, der durch ein jeweiliges Verstärkungsregelungssignal individuell gesteuert wird, das an den Anschluss (32) zum Ermöglichen einer automatischen Verstärkungsregelung angelegt wird,
eine Ausgangsleitung (34), die mittels eines Auswahlschalters (5), dessen Schaltzustand durch ein Auswahlsignal gesteuert wird, wahlweise mit einem gemeinsamen Ausgang der Verstärkungsschaltung verbindbar ist, und
wenigstens eine steuerbare Schalteinheit (31), die in der Verbindungsleitung zwischen dem Ausgangsanschluss des rauscharmen Verstärkers (4) und der Ausgangsleitung (34) des jeweiligen Verstärkungskanals platziert ist, wobei die steuerbare Schalteinheit (31) einen Abschnitt der Verbindungsleitung gemäß einem an ihr angelegten Schaltsteuersignal trennen oder verbinden kann.

2. Rauscharme Verstärkerschaltung nach Anspruch 1,
**dadurch gekennzeichnet,**
**dass** der Verstärkungsfaktor des rauscharmen Verstärkers (4) durch das Verstärkungssteuersignal stufenlos einstellbar ist.

3. Rauscharme Verstärkerschaltung nach Anspruch 1,
**dadurch gekennzeichnet,**
**dass** der rauscharme Verstärker (4) zwei Anschlüsse (32, 51) für eine automatische Verstärkungsregelung für eine stufenweise Verstärkungssteuerung der Verstärkung eines HF-Eingangssignals in ein HF-Ausgangssignal aufweist.

4. Rauscharme Verstärkerschaltung nach Anspruch 1, 2 oder 3,
**dadurch gekennzeichnet,**
**dass** der rauscharme Verstärker (4) und/oder die steuerbare Schalteinheit (31) und/oder der Auswahlschalter (5) in CMOS-Technik ausgeführt ist.

5. Rauscharme Verstärkerschaltung nach einem der Ansprüche 1 bis 4,
**dadurch gekennzeichnet,**
**dass** der rauscharme Verstärker (4) und/oder die steuerbare Schalteinheit (31) und/oder der Auswahlschalter (5) in BiCMOS-Technik ausgeführt ist.

6. Rauscharme Verstärkerschaltung nach einem der Ansprüche 1 bis 5,
**dadurch gekennzeichnet,**
**dass** der rauscharme Verstärker (4) und/oder die steuerbare Schalteinheit (31) und/oder der Auswahlschalter (5) in SiGe-Technik ausgeführt ist.

7. Rauscharme Verstärkerschaltung nach einem der Ansprüche 1 bis 6,
**dadurch gekennzeichnet,**
**dass** die rauscharme Verstärkerschaltung als eine integrierte Monolithschaltung oder als ein Teil davon ausgeführt ist.

8. Mehrband-HF-Empfänger, mit
einer rauscharmen Verstärkerschaltung nach einem der Ansprüche 1 bis 7, einer Einrichtung (78) für eine automatische Verstärkungsregelung zum getrennten Steuern des Verstärkungsfaktors jedes Verstärkungskanals der rauscharmen Verstärkerschaltung (72),
einer Mischeinrichtung (73) zum Mischen eines vom Ausgang der rauscharmen Verstärkerschaltung (72) empfangenen Signals mit einem Schwingfrequenzband, um es in ein niedrigeres Frequenzband umzusetzen, und
einer komplexen Filtereinrichtung (74) zum Filtern und Weiterverstärken eines von der Mischeinrichtung (73) empfangenen Signals.

9. Mehrband-HF-Empfänger nach Anspruch 8,
**gekennzeichnet durch**
einen automatischen Verstärkungsregelungsblock (75) zum Einstellen des Pegels eines von der komplexen Filtereinrichtung (74) empfangenen Signals auf die für die nachfolgende Basisbandverarbeitung eingestellten Anforderungen.

## Revendications

1. Circuit d'amplification de bruit faible destiné à un récepteur RF à bandes multiples ayant au moins deux canaux d'amplification distincts, moyennant quoi chaque canal d'amplification comprend
un amplificateur de bruit faible (4) ayant une borne d'activation de commande de gain automatique (32) permettant d'amplifier un signal d'entrée RF en un signal de sortie RF à un gain contrôlé de manière individuelle par un signal de commande de gain respectif appliqué à ladite borne d'activation de commande de gain automatique (32),
une ligne de sortie (34), qui peut être sélectivement reliée à une sortie commune du circuit d'amplification à l'aide d'un commutateur de sélection (5), dont la condition de commutation est contrôlée par un signal de sélection, et
au moins une unité de commutation contrôlable (31) sur la ligne de raccordement entre la borne de sortie dudit amplificateur de bruit faible (4) et ladite ligne de sortie (34) du canal d'amplification respectif, moyennant quoi ladite unité de commutation contrôlable (31) est adaptée afin de déconnecter ou de connecter une section de ladite ligne de raccordement selon un signal de commande de commutation appliqué à celle-ci.

2. Circuit d'amplification de bruit faible selon la revendication 1,
**caractérisé en ce que**
le gain de l'amplificateur de bruit faible (4) est ajustable en continu à l'aide dudit signal de commande de gain.

3. Circuit d'amplification de bruit faible selon la revendication 1,
**caractérisé en ce que**
ledit amplificateur de bruit faible (4) comprend deux bornes de commande de gain automatique (32, 51) destinées à effectuer une commande de gain progressive de l'amplification d'un signal d'entrée RF en un signal de sortie RF.

4. Circuit d'amplification de bruit faible selon la revendication 1, 2 ou 3,
**caractérisé en ce que**
ledit amplificateur de bruit faible (4) et/ou ladite unité de commutation contrôlable (31) et/ou ledit commutateur de sélection (5) est réalisé(e) avec une technologie CMOS.

5. Circuit d'amplification de bruit faible selon l'une des revendications 1 à 4,
**caractérisé en ce que**
ledit amplificateur de bruit faible (4) et/ou ladite unité de commutation contrôlable (31) et/ou ledit commutateur de sélection (5) est réalisé(e) avec une technologie BiCMOS.

6. Circuit d'amplification de bruit faible selon l'une des revendications 1 à 5,
**caractérisé en ce que**
ledit amplificateur de bruit faible (4) et/ou ladite unité de commutation contrôlable (31) et/ou ledit commutateur de sélection (5) est réalisé(e) avec une technologie SiGe.

7. Circuit d'amplification de bruit faible selon l'une des revendications 1 à 6,
**caractérisé en ce que**
ledit circuit d'amplification de bruit faible est réalisé comme un circuit intégré monolithique ou comme une partie de celui-ci.

8. Récepteur RF à bandes multiples comprenant
un circuit d'amplification de bruit faible selon l'une des revendications 1 à 7,
un moyen de commande de gain automatique (78) destiné à contrôler le gain de chaque canal d'amplification dudit circuit d'amplification de bruit faible (72) séparément,
un moyen de mélange (73) destiné à mélanger un signal reçu de la part de la sortie dudit circuit d'amplification de bruit faible (72) avec une bande de fréquences d'oscillation afin de le convertir en une bande de fréquences inférieure, et
un moyen de filtre complexe (74) destiné à filtrer et à amplifier un signal reçu de la part dudit moyen de mélange (73).

9. Récepteur RF à bandes multiples selon la revendication 8,
**caractérisé par**
un bloc de commande de gain automatique (75) destiné à ajuster le niveau d'un signal reçu de la part du moyen de filtre complexe (74) selon les exigences définies pour le traitement de bande de base ultérieur.
